# EUROPEAN PATENT APPLICATION

(11) **EP 4 841 842 A1**
(43) Date of publication of application: **18.11.2026**
(21) Application number: 26177057.2
(22) Date of filing: 06.05.2026
(51) Int. Cl.: H02H 3/16, H02H 7/04, H02H 3/04

(54) **TIME DOMAIN RESTRICTED EARTH FAULT PROTECTION**

(30) Priority: 16.05.2025 US 202519210020
(71) Applicant: Schweitzer Engineering Laboratories, Inc., Pullman, WA 99163 (US)
(72) Inventor: Fischer, Normann, Pullman, 99163 (US); Sawai, Sumit, Pullman, 99163 (US); Hostetler, John, Pullman, 99163 (US)
(74) Representative: Smith, Jeremy Robert

(57) **Abstract**

A power system includes a transformer, a three-phase current transformer that outputs a first signal indicative of a three-phase current conducting via the transformer and the three-phase current transformer, a neutral-current transformer that outputs a second signal indicative of a neutral current conducting via the transformer and the neutral-current transformer, and a controller. The controller may receive the first signal and the second signal, determine an operational current and a restraint current based on the three-phase current indicated by the first signal and the neutral current indicated by the second signal, determine whether the operational current is below a threshold value of the restraint current, and determine, based on the operational current being below the threshold value of the restraint current, the presence of an external ground fault condition of the transformer.

## Description

### BACKGROUND

This disclosure relates to transformer, generator and motor protection relays. More particularly, this disclosure relates to detecting earth a faults in a system that uses low-impedance or high-impedance grounded windings.

Electrical equipment, such as transformers, generators, and motors, include standardized ratings for current and power frequency voltage. To ensure that these limitations are not exceeded in order to prevent potential damage caused by unexpected currents and over voltages, protection systems may be utilized. Some protection schemes use current transformers. Current transformers are used to transform a received current by reducing the values of current. For example, current transformers may scale a supplied current to a suitable value for a secondary system, such as another current transformer and/or a relay. Current transformers may also be used to transform current to a level that may be monitored or measured using standardized equipment. These measurements may subsequently be used to make operation determinations for the transformer or generator being protected. Specifically, protection schemes utilizing current transformers may protect the transformer or generator from internal ground faults. Restricted Earth Fault (REF) protection is one type of protection approach that is often used to protect the transformer, motor or generator. An REF is an earth fault in a restricted or local zone of a circuit (e.g., transformer system circuit), and thus, REF protection includes protection within the restricted zone of the transformer system. However, accurate detection or determination of faults using the REF protection scheme may be made challenging by, for example, saturation of the transformer or measured currents that are particularly inductive or capacitive.

### BRIEF DESCRIPTION OF THE DRAWINGS

FIG. 1 is a block diagram of a transformer system with restricted earth fault protection, in accordance with an embodiment;
FIG. 2 is a block diagram of a restricted earth fault element used to determine internal and external ground faults, in accordance with an embodiment;
FIG. 3 is a logic diagram of logic that may be used to determine whether a condition for an external fault signal is present based on measurements in the time domain, in accordance with an embodiment;
FIG. 4 is a logic diagram of first logic that may be used to determine whether a condition for an internal fault signal is present based on measurements in the time domain, in accordance with an embodiment;
FIG. 5 is a logic diagram of second 2a and 2b logic that may be used to determine whether a condition for an internal fault signal is present based on measurements in the time domain, in accordance with an embodiment;
FIG. 6 is a logic diagram of third logic that may be used to determine whether a condition for an internal fault signal is present based on measurements in the time domain, in accordance with an embodiment; and
FIG. 7 is a logic diagram of fourth logic that may be used to determine whether a condition for an internal fault signal is present based on measurements in the time domain, in accordance with an embodiment.

### DETAILED DESCRIPTION

When introducing elements of various embodiments of the present disclosure, the articles "a," "an," and "the" are intended to mean that there are one or more of the elements. The terms "comprising," "including," and "having" are intended to be inclusive and mean that there may be additional elements other than the listed elements. Additionally, it should be understood that references to "one embodiment" or "an embodiment" of the present disclosure are not intended to be interpreted as excluding the existence of additional embodiments that also incorporate the recited features. Furthermore, the phrase A "based on" B is intended to mean that A is at least partially based on B. Moreover, unless expressly stated otherwise, the term "or" is intended to be inclusive (e.g., logical OR) and not exclusive (e.g., logical XOR). In other words, the phrase "A or B" is intended to mean A, B, or both A and B.

As discussed above, current transformers are transformers used to transform a received current, such as by reducing the values of current, to a value that may be measured by standardized equipment. For example, current transformers along with measuring instruments (e.g., sensors and/or ampere meter) are often used in protection schemes to measure the current flowing through the current transformers as a means for monitoring the transformer being protected in the transformer system.

A variety of protection schemes may be used to mitigate potential damage caused by unintended conditions (e.g., faults) in the transformers and the low impedance grounded generator or motor system. Without the protection schemes, these unintended operations may cause faults that damage the transformer system and/or system components. Overcurrent elements, such as fuses and/or relays with circuit breakers, may be used to protect transformers from high currents, such as a current that is larger than the current transformer's current rating. When a circuit breaker is unavailable or inaccessible, fuses may be used to protect small current transformers (e.g., rating of 1 mega volt amp (MVA) distribution voltage) by breaking an electrical connection of a conductor conducting the high current, thereby interrupting the current and protecting the transformer from potential damage from the high current. When a circuit breaker is available, a relay and a circuit breaker may be used to trip or disconnect the circuit from the current transformer upon detection of the high current. However, these protection mechanisms may not provide adequate protection for transformer windings.

Restricted earth fault (REF) protection may be used for protection against earth faults in the grounded windings of a transformer, generator, shunt reactor, or motor. In general, an earth fault includes a fault between a live conductor and the earth (e.g., ground), often occurring due to insulation breakdown. When the fault occurs, short circuit currents may flow through the system and return through the earth or electrical equipment that may cause damage to the overall equipment. In particular, the REF is an earth fault in a restricted or confined zone of a circuit, and thus, REF protection provides protection within the restricted zone of the transformer. The restricted zone may be characterized by a neutral current and sum of three-phase current on wye-connected windings.

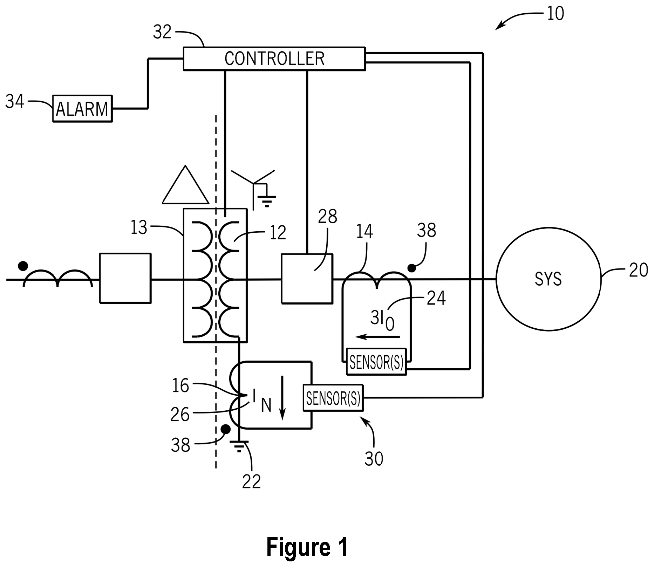

To illustrate, FIG. 1 depicts a block diagram of a transformer system 10 with REF protection that may protect a wye winding 12 (e.g., star winding) of a transformer 13. In the depicted example, the transformer 13 of the transformer system 10 may be connected to (e.g., may provide power to) a power system 20. As shown, the REF protection of the transformer system 10 in the current example is restricted to a zone between a three-phase current transformer 14 and a neutral-current transformer 16 that are connected to the wye winding 12 of the transformer 13. In particular, the zero-sequence current 24 measured in the three-phase current transformer 14 and the neutral current 26 measured in the neutral-current transformer 16 will have the opposite polarity and equal magnitude during external faults outside the REF protection zone. When the fault is inside of the REF protection zone, the zero-sequence current 24 and the neutral current 26 may not have the opposite polarity and/or may operate a protective relay. The three-phase current transformer 14 may include three sets of primary and secondary windings (e.g., three-single phase current transformers) that are each connected to one of the three-phase wye windings (not shown) of the transformer 13. The neutral-current transformer 16 may be connected to the neutral of the transformer 13 and ground 22. As will be described herein, both the three-phase current transformer 14 and the neutral-current transformer 16 may be used to transform currents to and from the wye windings 12 and/or the transformer 13 to a measurable level that may be measured by a measuring device, such as one or more sensors 30. The measurements may be subsequently used to perform mitigating actions when the detected current level indicates that a fault condition may be present.

Under normal operating conditions, the sum of currents flowing into the conducting network from both the three-phase current transformer 14 and the neutral-current transformer 16 is approximately zero (e.g., a zero-sequence network). That is, the sum of a three-phase current 24 (3I0) from the three-phase current transformer 14 and a neutral current 26 (IN) from the neutral-current transformer 16 is approximately equal to zero. Although not shown, the three-phase current 24 may include the sum of a first current (IA), a second current (IB) and a third current (IC) corresponding to a current conducting via each of the wye windings 12.

If a fault is present in the wye windings 12, the sum of the three-phase current 24 and the neutral current 26 is not zero. For example, if an internal ground fault occurs at circuit breaker 28, then the system 20 may contribute some zero-sequence current measured by the three-phase current transformer 14. The zero-sequence current measured by the three-phase current transformer 14, however, may not be the same amount and opposite polarity of current measured by the neutral-current transformer 16 (e.g., neutral current 26). As such, the sum of the three-phase current 24 and the neutral current 26 is not zero, thereby indicating that a fault condition may be present within the restricted zone.

To measure the three-phase current 24 and the neutral current 26, one or more sensors 30 may be located on the three-phase current transformer 14, on the neutral-current transformer 16, or elsewhere in the transformer system 10. The measured currents may be sent to a controller 32, which may determine whether a fault condition is present and subsequently control the circuit breaker 28, the system 20, and/or an alarm 34 in response to the fault condition being present. For example, upon detection of a fault condition, the controller 32 may send a trip command to the circuit breaker 28 to trip (e.g., switch to open) and disconnect the transformer 13 the system 20 in order to protect the transformer 13 and or the system 20 from damage that may otherwise occur due to the fault. Additionally or alternatively, the controller 32 may transmit an alarm signal (e.g., notification) to the alarm 34 or a control system to indicate that a fault exists.

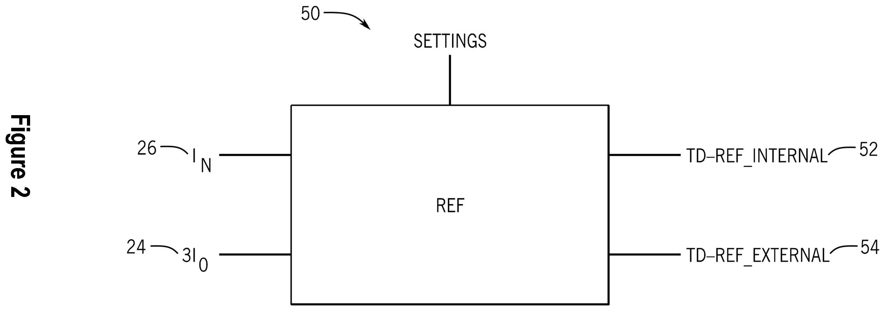

Although not shown, the controller 32 may include a microprocessor, a non-volatile memory, and/or a user interface. The microprocessor may include any type of processing circuitry, such as one or more processors, one or more "general-purpose" microprocessors, one or more special-purpose microprocessors, and/or one or more application specific integrated circuits (ASICS), or some combination thereof. For example, the microprocessor may include one or more reduced instruction set (RISC) processors. The processor may process instructions stored in the memory to determine operations and faults, as will be discussed with reference to FIGS. 2-6. Moreover, the processor may process the instructions to command components to actuate (e.g., switch circuit breaker 28 to open or close) based on the determined faults, and so forth.

The memory may store instructions, data, and/or information, such as an algorithm used for determining internal or external ground faults based on stored data (e.g., predetermined current thresholds) and/or received data (e.g., measured three-phase current 24 and neutral current 26 data via the sensors 30). The memory may be a tangible, non- transitory, computer-readable medium that stores sensor data and/or instructions executable by the processor. Thus, in some examples, the memory may include random access memory (RAM), read only memory (ROM), rewritable non-volatile memory, flash memory, hard drives, optical discs, and the like.

Furthermore, in some examples, the controller 32 may be communicatively coupled to and/or include a user interface that provides information to and/or receives information from a user (e.g., operator). In some examples, the user may control or override the controller 32, such as to manually command a maintenance operation or a mitigating operation (e.g., command circuit breaker 28 to switch to open) to prevent potential damage that may occur in the transformer system 10 due to a fault. The user interface may include any suitable combination of input and output devices, such as an electronic display, a touchscreen, a stylus, a keypad, a button, and/or the like, to enable communicating system fault and/or system information to a user. Moreover, in some examples, the controller 32 may be communicatively coupled to and/or include a communication interface that may enable communication with any suitable communication network, such as wiring terminals, a cellular network, a Wi-Fi network, a personal area network (PAN), a local area network (LAN), a wide area network (WAN), and/or the like. For example, the communication interface may enable the controller 32 to communicate with a user interface implemented on a user's mobile device, which may also be communicatively coupled to the communication network.

FIG. 2 depicts a block diagram of an REF element 50 used to determine internal and external ground faults (e.g., internal and external ground fault conditions). In some examples, the REF element 50 may communicate with the controller 32 of FIG. 1 or may be integrated with the controller 32. As shown, the REF element 50 may receive two input values, such as the neutral current 26 (IN) and the three-phase current 24 (3I0), to determine whether an output fault is present. As previously discussed, these input values may be used to determine where the fault condition is present. For example, the REF element 50 may, based on these inputs values, determine that an internal ground fault 52 (TD-REF_INTERNAL) and/or an external ground fault 54 (TD-REF_EXTERNAL) is present.

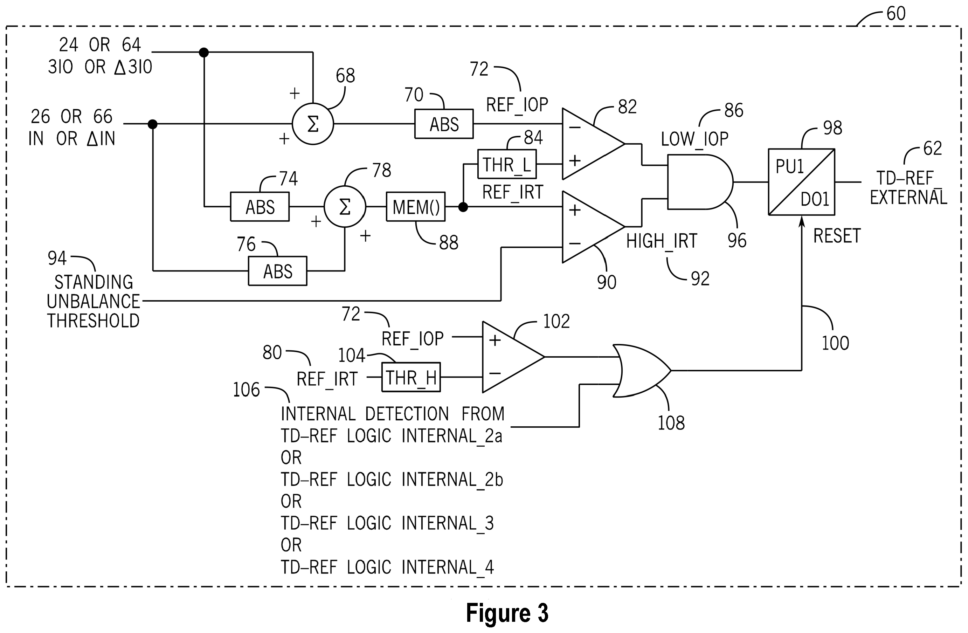

FIG. 3 illustrates a logic diagram of logic 60 that may be used to determine whether a condition for an external fault signal (TD-REF_EXTERNAL) 62 is present based on current measurements in the time domain. The logic 60 may implemented as, for example, a non-transitory computer-readable medium of the REF element 50 that may store instructions that, when executed by a processor of the REF element 50, may cause the processor to perform various methods and/or operations of the logic 60. Additionally or alternatively, the logic may be implemented in hardware of the REF element 50, such as by a hardware-implemented finite state machine of the REF element 50. The logic 60 may accept, as input, a zero-sequence (3I0) 24 current, and a neutral current (IN) 26. The logic 60 may also accept, as input, The zero-sequence incremental current (Δ3I0) 64 and the neutral incremental current (ΔIN) 66 , such that they indicate a change from one measurement cycle to the next. For example, the Δ3I0 64 may be based on a one-cycle difference of the zero-sequence of the three-phase current 24 (3I0), and the (ΔIN) 66 may be based on a one-cycle difference of the neutral current 26. By including incremental values, the Δ3I0 64 and the ΔIN 66 may more accurately characterize current measurements when the transformer system 10 is in an unbalanced condition.

The logic 60 of FIG. 3 depicts a summer 68 in series with an absolute value block 70 that together determine an operational current (REF_IOP) 72 equal to the absolute value of the sum of the Δ3I0 64 and the ΔIN 66. In addition, the logic 60 includes an absolute value block 74 of the Δ3I0 64 and an absolute value block 76 of the ΔIN 66. A summer 78 may sum the output of the absolute value blocks 74 and 76 to determine a restraint current (REF_IRT) 80 equal to the sum of the absolute value of the Δ3I0 64 and the absolute value of the ΔIN 66. Because the restraint current may change values rapidly, the logic 60 may include a memory component 88 that may perform a capacitor and/or filtering function of the restraint current 80. For example, the memory component 88 may reduce a rate or frequency at which the restraint current 80 approaches zero, which may allow the logic 60 to accurately determine TD-REF_EXTERNAL 62 based on the restraint current 80.

For example, a comparator 82 may compare the operational current (REF_IOP) 72 to a threshold percentage 84 of the restraint current 80 to determine a low operational current (LOW_IOP) indication 86. The threshold percentage 84 may be 1%, 5%, 20%, or the like, of the restraint current 80, for instance, and may be set according to sensitivity settings or other design specifications. The LOW_IOP indication 86 may be a high value if the operational current 72 is below the threshold percentage 84 of the restraint current 80. Further, the operational current 72 being below the threshold percentage 84 of the restraint current 80 may be used to determine an external fault, as the Δ3I0 64 and the ΔIN 66 may be proximate in magnitude but may have opposite polarity during such an external fault. The logic 60 may also include a comparator 90 that produces a HIGH_IRT indication 92 (e.g., restraint threshold indication) based on a comparison between the restraint current 80 and a noise threshold 94. The HIGH_IRT indication 92, when at a high value, may indicate that the restraint current 80 is not merely a product of noise of the transformer system 10.

An AND gate 96 may receive the LOW_IOP indication 86 indication and the HIGH_IRT indication 92 and may produce a high value if both the LOW_IOP 86 indication and the HIGH_IRT indication 92 are high values. This may indicate that the operational current 72 is below the threshold percentage 84 of the restraint current 80 and that the restraint current 80 is not impacted significantly by noise. An output of the AND gate 96 may be provided to a counter 98, and the counter 98 may set the TD-REF_EXTERNAL 62 high if the output of the AND gate 96 is high for a certain number of cycles. As mentioned, a high TD-REF_EXTERNAL 62 may indicate an external fault of the transformer system 10.

Once the counter 98 sets the TD-REF_EXTERNAL 62 high, it may reset the TD-REF_EXTERNAL 62 (e.g., to a low value) based on a reset signal 100. For example, a comparator 102 may compare the operational current 72 to a threshold percentage 104 of the restraint current 80. If the operational current 72 is above the threshold percentage 104 of the restraint current 80, the comparator may produce a high output. This may indicate, for example, that the operational current 72 has changed to internal fault levels and that an external fault has evolved into internal fault. The output of the comparator 102, along with other logic 106 that may indicate that an external fault is no longer present, may be provided to an OR gate 108 that may produce the reset signal 100. A high reset signal 100 may reset the TD-REF_EXTERNAL 62 to a low value and/or may reset a sample count of the counter 98. It should be noted, however, that the counter 98 may "seal" a high TD-REF_EXTERNAL 62 value for a number of cycles or samples after determining that the high TD-REF_EXTERNAL 62 is present, such that the counter 98 is not reset by a high reset signal 100 for the number of cycles or samples.

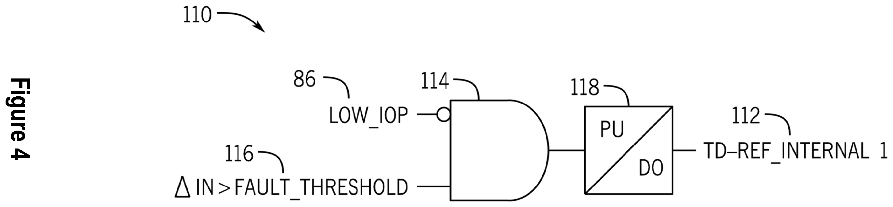

FIG. 4 is a logic diagram of logic 110 that may be used to determine whether a condition for a first internal fault signal (TD-REF_INTERNAL_1) 112 is present based on measurements in the time domain. The logic 110 used to determine an internal fault may be used in conjunction with the logic 60 of FIG. 3 to determine an external fault. For example, the REF element 50 may first determine whether an external fault is present using the logic 60 and may then determine whether an internal fault is present using the logic 110. Further, the logic 110 used to determine an internal fault may use signals, determinations, and the like from the logic 60 used to determine an external fault.

For example, the logic 110 may accept as input at an AND gate 114, a negation of the LOW_IOP indication 86 used in the logic 60. The negation of the LOW_IOP indication 86 may indicate that whether the operational current 72 is greater than the threshold percentage 84 of the restraint current 80, which may indicate that an internal fault is present. In addition, the AND gate 114 may accept, as input, a second indication 116 of whether the ΔIN 66 is greater than a fault threshold. As mentioned, the ΔIN 66 may indicate a one-cycle difference in the neutral current 26 flowing into the conducting network, and thus the second indication 116, when high, may indicate a sharp increase in the neutral current 26.

If the inverse of the LOW_IOP indication 86 indicates that the operational current 72 is greater than the threshold percentage 84 of the restraint current 80 and the second indication 116 indicates the ΔIN 66 is above a fault threshold, the AND gate 114 may produce a high value. The high value may indicate, referring to FIG. 1, that an internal fault is present in the transformer 13. The high value, when provided to a counter 118 for a certain number of counts (e.g., cycles, samples), may cause the counter 118 to drive the TD-REF_INTERNAL_1 112 to a high value for an amount of time (e.g., to "seal in" the high value). In some cases, the counter 118 may be reset to a low value after producing a high TD-REF_INTERNAL_1 112 value by additional reset circuitry.

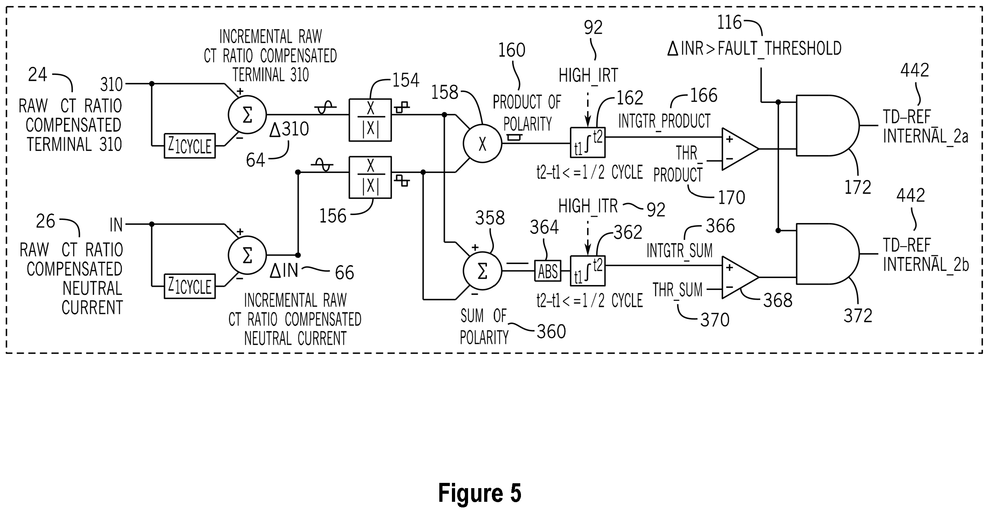

Additionally or alternatively, an internal fault may be detected based on a polarity of the ΔIN 66 and the Δ3I0 64. FIG. 5 is a logic diagram of logic 150 that may be used to determine whether a condition for a second and third internal fault signal (TD-REF_INTERNAL_2a, TD-REF_INTERNAL_2b) 152 and 352 is present based on measurements in the time domain. The logic 150 may be used in conjunction with the logic 60 for determining an external fault and/or the logic 110 for determining an internal fault. For example, the logic 150 may be used to determine an internal fault after the logic 60 is used to determine an external fault and/or after the logic 110 is used to determine an internal fault (e.g., as an internal fault redundancy measure).

The logic 150 may accept, as input, the Δ 3I0 64 and the Δ IN 66 which, as mentioned, may include a one-cycle difference of the inverse of a measured three-phase current and a one-cycle difference of a measured neutral current, respectively. As illustrated, the Δ 3I0 64 may be provided to a first polarity block 154 that determines a polarity of the Δ 3I0 64, and the Δ IN 66 may be provided to a second polarity block 156 that determines a polarity of the Δ IN 66. The polarity of the Δ 3I0 64 and the polarity of the Δ IN 66 may be provided to a multiplication block 158 that may determine a product 160 of the polarities. The product 160 of the polarity determined by the multiplication block 158 may indicate a polarity relationship of the Δ 3I0 64 and the Δ IN 66, which may indicate the presence of an internal fault. For example, if an internal fault is present, the polarities of the Δ 3I0 64 and the Δ IN 66 may be the same (e.g., both positive or both negative), and the product 160 of the polarities may thus be positive. On the other hand, if an internal fault is not present and/or an external fault is present, the polarities of the Δ 3I0 64 and the Δ IN 66 may be different, and the product 160 of the polarities may thus be negative.

An integrator 162 may integrate the product 160 of the polarities to generate an INTGR_PRODUCT 166. The integrator 162 may select a subset (e.g., over a time window) of the products 160 based on, for example, the second indication HIGH_IRT 92 of whether the REF_IRT is greater than a standing unbalance threshold 94 for each sample of the products 160. The size of the subset may be set at manufacture according to design specifications, at runtime, and so on. The selected products may be integrated over a period that results in a sum of the selected products, and the INTGR_PRODUCT 166 may be provided to a comparator 168. The comparator 168 may compare the summed products 166 to a threshold THR_PRODUCT 170 and may produce a high output if the summed products 166 are above the threshold.

The threshold THR_PRODUCT 170 may be determined based on a size of the integration window used to generate the integrated products 166 (e.g., a number of products 160 integrated by the integrator 162). For an external fault, the integrator 162 may produce a negative answer equal to size of the integrator window. For an internal fault, the integrator 162 may produce a positive answer equal to the size of integration window (number of products 160 integrated). Further, in some cases, , the threshold THR_PRODUCT 170 may be selected greater than zero (e.g., to provide additional security). The output of the comparator 168 may be provided to an AND gate 172 along with an indication 116 whether the ΔIN is greater than the fault threshold. The indication 116 may be determined as the negation of the TD-REF_EXTERNAL 62, for example. As such, if the summed products 166 are above the threshold sum (THR_PRODUCT) 170 and the indication 116 indicates that Δ IN is greater than the fault threshold, the AND gate 172 may produce a logic high TD-REF_INTERNAL_2a 152.

The polarity of the Δ 3I0 64 and the polarity of the Δ IN 66 may be provided to a summation block 358 that may determine a sum 360 of the polarities. The sum 360 of the polarity determined by the summation block 358 may indicate a polarity relationship of the Δ 3I0 64 and the Δ IN 66, which may indicate the presence of an internal fault. The sum 360 of the polarities may be provided to absolute block 364 to produce a positive sum 360, which may be provided to the integrator 362 to generate integrated sums INTGTR_SUM 366. The integrator 362 may select a subset (e.g., over a time window) of the sums 360 based on, for example, a second indication HIGH_IRT 92 of whether the REF_IRT is greater than a standing unbalance threshold 94 for each sample of the sum 360. The size of the subset may, for example, be set at manufacture according to design specifications, at runtime, and so on. The INTGR_SUM 366 may be provided to a comparator 368. The comparator 368 may compare the integrated sums 366 to a threshold THR_SUM 370 and may produce a high output if the integrated sums 366 are above the threshold.

The threshold THR_SUM 370 may be determined based on a size of the integration window (e.g., a number of sums 360 integrated to generate the integrated sums 366). For an external fault, the integrator 362 may produce an answer of zero. For an internal fault, the integrator 362 may produce a positive answer equal to twice the size of integration window . Further, in some cases, the THR_SUM 370 may be elected more than the size of integration window and less than twice of the size of integration window (e.g., to provide additional security). For example, for an integration window of eight summed products, the THR_SUM 370 may be nine, such that the THR_SUM 370 is greater than size of integration window but less than twice the size of the integration window. The output of the comparator 368 may be provided to an AND gate 372 along with the indication 116 that the Δ IN is greater than the fault threshold, which may be determined, as mentioned, as the negation of the TD-REF_EXTERNAL 62. As such, if the integrated sums 366 are above the threshold sum 370 and the indication 116 is high, the AND gate 372 may produce a logic high TD-REF_INTERNAL_2b 352.

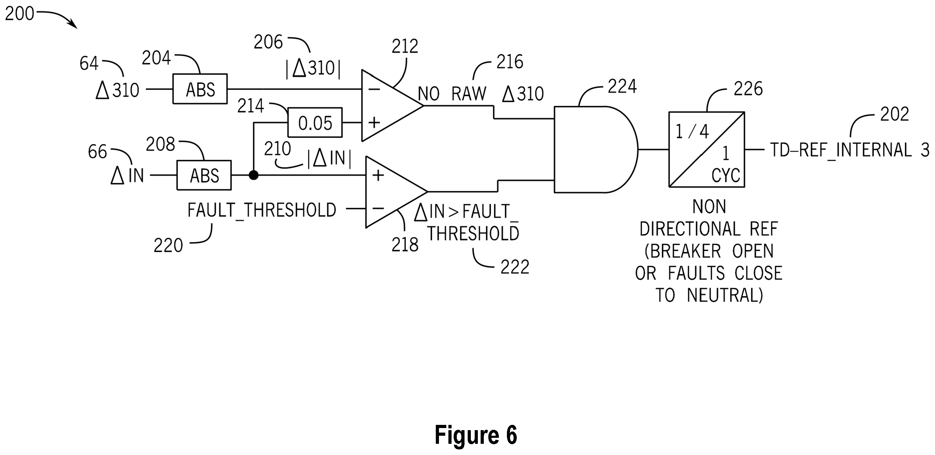

FIG. 6 is a logic diagram of logic 200 that may be used to determine whether a condition for a third internal fault signal (TD-REF_INTERNAL_3) 202 is present based on measurements in the time domain. The logic 200 may be used in conjunction with the logic 60 for determining an external fault, the logic 110 for determining an internal fault, and/or the logic 150 for determining an internal fault. For example, the logic 200 may be used to determine an internal fault after the logic 60 is used to determine an external fault. In another example, the logic 200 may be used in conjunction with the logic 110 to determine that an internal fault has occurred in which, referring to FIG. 1, the breaker 28 is open.

As part of the logic 200, the Δ 3I0 64 may be provided to a first absolute value block 204 to produce a positive Δ 3I0 206, and the Δ IN 66 may be provided to a second absolute value block 208 to produce a positive Δ IN 210. A first comparator 212 may compare the positive Δ 310 206 to a threshold percentage 214, here illustrated as 5%, of the positive Δ IN 210 to produce a first indication 216. If the positive Δ 3I0 206 is less than the threshold percentage 214 of the positive Δ IN 210, the first comparator 212 may produce the first indication 216 as a high value, for instance. This may indicate, referring to FIG. 1, that the zero-sequence current 24 is a relatively low value, which may result from the breaker 28 being open, the power system 20 consisting only of a load and not having any source to supply fault current, and/or the fault being proximate the neutral of the transformer winding. In addition, a second comparator 218 may compare the positive Δ IN 210 to a fault threshold 220 and may produce a second indication 222. For example, if the positive Δ IN 210 is above the fault threshold 220, the second comparator 218 may produce the second indication 222 as a logic high.

An AND gate 224 may produce an output based on the first indication 216 that the positive Δ 310 206 is below the threshold percentage 214 and the second indication 222 that the positive Δ IN 210 is above the fault threshold 220. For example, if the first indication 216 and the second indication 222 are both high, the AND gate 224 may produce a high output, which may indicate that the positive Δ 3I0 206 is relatively low (e.g., the breaker 28 is open) and the positive Δ IN 210 is relatively high (e.g., neutral current is flowing into the transformer 13). If the AND gate 224 produces a high value for a number of counts (e.g., cycles, samples, seconds), a counter 226 may set the TD-REF_INTERNAL_4 202 high. In an example, the counter 226 sets the TD-REF_INTERNAL_3 202 high for an amount of time and/or until reset by additional circuitry.

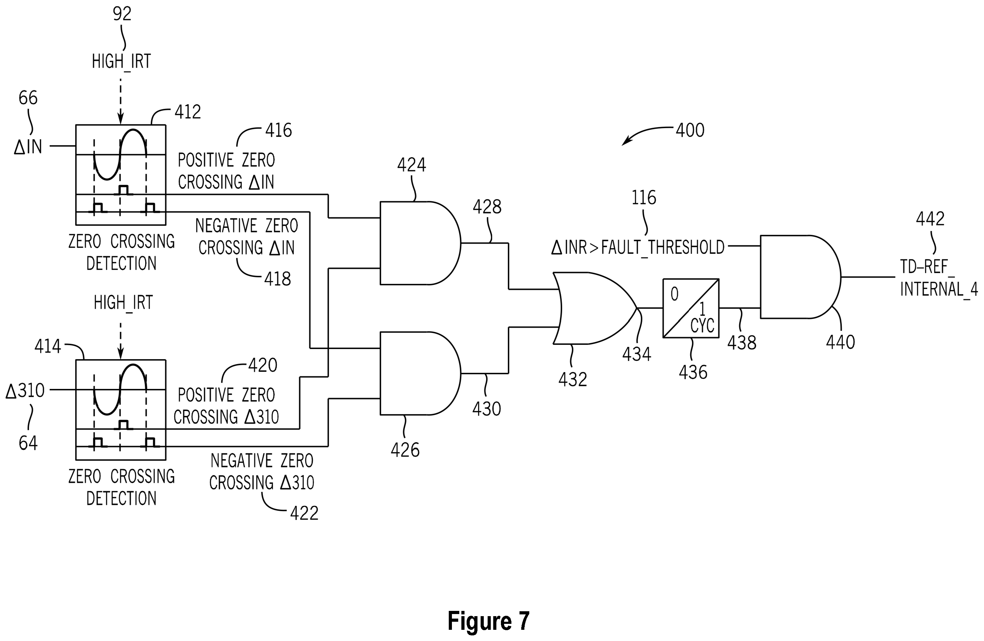

FIG. 7 is a logic diagram of logic 400 that may be used to determine whether a condition for a fourth internal fault signal (TD-REF_INTERNAL_4) 442 is present based on measurements in the time domain. The logic 400 used to determine an internal fault may be used in conjunction with the logic 60 to determine an external fault. For example, the REF element 50 may first determine whether an external fault is present using the logic 60 and may then determine whether an internal fault is present using the logic 400. Further, the logic 400 used to determine an internal fault may use signals, determinations, and the like from the logic 60 used to determine an external fault. The logic 400 may accept, as input, the Δ 310 64 and the Δ IN 66 which, as mentioned, may include a one-cycle difference of the inverse of a measured three-phase current and a one-cycle difference of a measured neutral current, respectively. As illustrated, the Δ 310 64 may be provided to a first zero crossing block 412 that detects a zero crossing of the Δ IN 66, and the Δ 3I0 64 may be provided to a second zero crossing block 414 that determines a zero crossing of the Δ 310 66. The zero-crossing detector block may be supervised by the indication 92, which may, as mentioned, indicate whether the restraint current 80 is above a noise threshold (e.g., not merely a product of noise of the transformer system 10). The first zero crossing block 412 and the second zero crossing block 414 may only generate outputs when the indication 92 is present or comes up within half cycle after detecting a zero crossing, for instance.

The zero crossing detector block 412 produces a positive zero crossing output Δ IN 416 when the polarity of the signal Δ 3I0 64 changes from negative to positive. Once detected, the output 416 may be held for 1/8^{th} of a power system cycle. The zero-crossing detector block 412 produces a negative zero crossing output Δ IN 418 when the polarity of the signal Δ 3I0 64 changes from positive to negative. Once detected, the output 418 may be held for 1/8^{th} of a power system cycle. The zero crossing detector block 414 produces a positive zero crossing output Δ 3I0 420 when polarity of signal Δ IN 66 changes from negative to positive Once detected, the output 420 may be held for 1/8^{th} of a power system cycle. The zero crossing detector block 414 produces a negative zero crossing output Δ 3I0 422 when the polarity of the signal Δ IN 66 changes from positive to negative Once detected, the output 422 may be held for 1/8^{th} of a power system cycle.

The output 416 and 420 (e.g., the positive zero crossing indications) may be provided as input to an AND gate 424 to generate an internal fault indicator 428, which may indicate that the currents Δ IN 66 and Δ 310 64 have the same polarity and may indicate internal fault. The output 418 and 422 (negative zero crossing indication) may be provided as input to an AND gate 426 to generate an internal fault indicator 430, which may indicate that the currents Δ IN 66 and Δ 310 64 have the same polarity and may indicate internal fault. Both of the internal fault indicators 428 and 430 are provided to an OR gate 432 that may produce a single indication 434 for an internal fault. The indication 434 may be provided to a drop down counter 436, which may generate and hold (e.g., for one power system cycle) an output 438 high in response to the indication 434 being high. The counter 436 allows for better co-ordination between the indication 434 for the internal fault and the indication 116 that ΔIN is greater than the fault threshold. An AND gate 440 may accept, as input, the output 438 and the indication 116 that ΔIN is greater than the fault threshold to produce a final output T-REF_INTERNAL_4 442 (e.g., as a fourth internal fault detector).

In accordance with several embodiments is a power system, comprising: a first transformer; a three-phase current transformer configured to output a first signal indicative of a three-phase current conducting via the first transformer and the three-phase current transformer; a neutral-current transformer configured to output a second signal indicative of a neutral current conducting via the first transformer and the neutral-current transformer; and a controller configured to: receive the first signal and the second signal; determine an operational current and a restraint current based on the three-phase current indicated by the first signal and the neutral current indicated by the second signal; determine whether the operational current is below a threshold value of the restraint current; and determine, based on the operational current being below the threshold value of the restraint current, the presence of an external ground fault condition of the first transformer. The first signal may be indicative of a zero-sequence of the three-phase current in the time domain and the second signal is indicative of the neutral current in the time domain. The controller may be configured to transmit one or more alarms to a control system based on the external ground fault condition being present. The first signal may be indicative of a first one-cycle difference of the three-phase current, wherein and the second signal is indicative of a second one-cycle difference of the neutral current. The controller may be configured to determine the presence of an internal ground fault condition based on the operational current not being below the threshold value of the restraint current and the second signal indicating that the neutral current is above a fault threshold. The controller may be configured to determine the presence of an internal ground fault condition based on one or more samples, each of the one or more samples comprising a product of a first polarity of a zero sequence of the three-phase current and a second polarity of the neutral current. The controller may be configured to determine the presence of an internal ground fault condition of the first transformer based on the one or more samples based on: calculating a sum of the products of the one or more samples; and comparing the sum of the products to a threshold sum. The controller may be configured to: determine a first magnitude of the three-phase current indicated by the first signal and a second magnitude of the neutral current indicated by the second signal; determine whether the first magnitude is below an additional threshold value of the second magnitude; and determine, based on the first magnitude being below the additional threshold value of the second magnitude, the presence of an internal ground fault condition of the first transformer. The controller may be configured to transmit a first signal indicating the external ground fault condition of the first transformer based on the presence of the external ground fault condition of the first transformer for a number of cycles of the three-phase current transformer, the neutral-current transformer, or both. The controller may be configured to transmit a second signal indicating that no external ground fault condition of the first transformer is present based on the restraint current being above a restraint threshold.

In various embodiments is a method for detecting an internal ground fault or an external ground fault of a grounded wye winding to protect equipment of a power system comprising the grounded wye winding, the method comprising: receiving a first signal from a three-phase current transformer, wherein the first signal is indicative of a three-phase current conducting via the grounded wye winding and the three-phase current transformer; receiving a second signal from a neutral-current transformer, wherein the second signal is indicative of a neutral current conducting via the grounded wye winding and the neutral-current transformer; determining an operational current and a restraint current based on the three-phase current indicated by the first signal and the neutral current indicated by the second signal; determining whether the internal ground fault of the grounded wye winding is present based on the operational current not being below a threshold value of the restraint current and the second signal indicating that the neutral current is above a fault threshold; and transmitting a notification to a computing system based on the internal ground fault being present. The method may include determining, based on the operational current being below the threshold value of the restraint current, the presence of an external ground fault condition of the grounded wye winding; and transmitting the notification to a computing system based on the external ground fault condition being present. The presence of the internal ground fault of the grounded wye winding may be determined based on: determining a first magnitude of a zero sequence of the three-phase current indicated by the first signal and a second magnitude of the neutral current indicated by the second signal; determining whether the first magnitude is below an additional threshold value of the second magnitude; and determining, based on the first magnitude being below the additional threshold value of the second magnitude, the presence of the internal ground fault of the grounded wye winding. The first signal may be indicative of a zero-sequence of the three-phase current in the time domain and the second signal is indicative of the neutral current in the time domain, and wherein the first signal is indicative of a first one-cycle difference of the three-phase current, and the second signal is indicative of a second one-cycle difference of the neutral current. The grounded wye winding may be included as part of a transformer, generator, shunt reactor, or motor of the power system.

In various embodiments is a tangible, non-transitory, computer-readable medium storing instructions executable by one or more processors, wherein the instructions, when executed, are configured to cause the one or more processors to: receive a first signal from a three-phase current transformer, wherein the first signal is indicative of a three-phase current conducting via a transformer and the three-phase current transformer; receive a second signal from a neutral-current transformer, wherein the second signal is indicative of a neutral current conducting via the transformer and the neutral-current transformer; determine an operational current and a restraint current based on the three-phase current indicated by the first signal and the neutral current indicated by the second signal; determine whether the operational current is below a threshold value of the restraint current; and determine, based on the operational current being below the threshold value of the restraint current, the presence of an external ground fault condition of the transformer. The instructions are configured to cause the one or more processors to determine the presence of an internal ground fault condition of the transformer based on the operational current not being below the threshold value of the restraint current and the second signal indicating that the neutral current is above a fault threshold. The instructions may be configured to cause the one or more processors to transmit one or more alarms to a control system based on the external ground fault condition being present. The first signal may be indicative of a first one-cycle difference of the three-phase current, and the second signal may be indicative of a second one-cycle difference of the neutral current. The instructions may be configured to cause the one or more processors to transmit a first signal indicating the external ground fault condition of the transformer based on the presence of the external ground fault condition of the transformer for a number of cycles of the three-phase current transformer, the neutral-current transformer, or both.

While specific embodiments and applications of the disclosure have been illustrated and described, it is to be understood that the disclosure is not limited to the precise configurations and components disclosed herein. For example, the systems and methods described herein may be applied to an industrial electric power delivery system or an electric power delivery system implemented in a boat or oil platform that may or may not include long-distance transmission of high-voltage power. Accordingly, many changes may be made to the details of the above-described embodiments without departing from the underlying principles of this disclosure. The scope of the present disclosure should, therefore, be determined only by the following claims.

Indeed, the embodiments set forth in the present disclosure may be susceptible to various modifications and alternative forms, specific embodiments have been shown by way of example in the drawings and have been described in detail herein. However, it may be understood that the disclosure is not intended to be limited to the particular forms disclosed. The disclosure is to cover all modifications, equivalents, and alternatives falling within the spirit and scope of the disclosure as defined by the following appended claims. In addition, the techniques presented and claimed herein are referenced and applied to material objects and concrete examples of a practical nature that demonstrably improve the present technical field and, as such, are not abstract, intangible or purely theoretical. Further, if any claims appended to the end of this specification contain one or more elements designated as "means for [perform]ing [a function]..." or "step for [perform]ing [a function]...", it is intended that such elements are to be interpreted under 35 U.S.C. 112(f). For any claims containing elements designated in any other manner, however, it is intended that such elements are not to be interpreted under 35 U.S.C. 112(f).

## Claims

1. A power system, comprising:
a first transformer;
a three-phase current transformer configured to output a first signal indicative of a three-phase current conducting via the first transformer and the three-phase current transformer;
a neutral-current transformer configured to output a second signal indicative of a neutral current conducting via the first transformer and the neutral-current transformer; and
a controller configured to:
receive the first signal and the second signal;
determine an operational current and a restraint current based on the three-phase current indicated by the first signal and the neutral current indicated by the second signal;
determine whether the operational current is below a threshold value of the restraint current; and
determine, based on the operational current being below the threshold value of the restraint current, the presence of an external ground fault condition of the first transformer.

2. The power system of claim 1, wherein the first signal is indicative of a zero-sequence of the three-phase current in the time domain and the second signal is indicative of the neutral current in the time domain.

3. The power system of claim 1, wherein the controller is configured to transmit one or more alarms to a control system based on the external ground fault condition being present.

4. The power system of claim 1, wherein the first signal is indicative of a first one-cycle difference of the three-phase current, wherein and the second signal is indicative of a second one-cycle difference of the neutral current.

5. The power system of claim 1, wherein the controller is configured to determine the presence of an internal ground fault condition based on the operational current not being below the threshold value of the restraint current and the second signal indicating that the neutral current is above a fault threshold.

6. The power system of claim 1, wherein the controller is configured to determine the presence of an internal ground fault condition based on one or more samples, each of the one or more samples comprising a product of a first polarity of a zero sequence of the three-phase current and a second polarity of the neutral current.

7. The power system of claim 6, wherein the controller is configured to determine the presence of an internal ground fault condition of the first transformer based on the one or more samples based on:
calculating a sum of the products of the one or more samples; and
comparing the sum of the products to a threshold sum.

8. The power system of claim 1, wherein the controller is configured to:
determine a first magnitude of the three-phase current indicated by the first signal and a second magnitude of the neutral current indicated by the second signal;
determine whether the first magnitude is below an additional threshold value of the second magnitude; and
determine, based on the first magnitude being below the additional threshold value of the second magnitude, the presence of an internal ground fault condition of the first transformer.

9. The power system of claim 1, wherein the controller is configured to transmit a first signal indicating the external ground fault condition of the first transformer based on the presence of the external ground fault condition of the first transformer for a number of cycles of the three-phase current transformer, the neutral-current transformer, or both.

10. The transformer system of claim 9, wherein the controller is configured to transmit a second signal indicating that no external ground fault condition of the first transformer is present based on the restraint current being above a restraint threshold.

11. A method for detecting an internal ground fault or an external ground fault of a grounded wye winding to protect equipment of a power system comprising the grounded wye winding, the method comprising:
receiving a first signal from a three-phase current transformer, wherein the first signal is indicative of a three-phase current conducting via the grounded wye winding and the three-phase current transformer;
receiving a second signal from a neutral-current transformer, wherein the second signal is indicative of a neutral current conducting via the grounded wye winding and the neutral-current transformer;
determining an operational current and a restraint current based on the three-phase current indicated by the first signal and the neutral current indicated by the second signal;
determining whether the internal ground fault of the grounded wye winding is present based on the operational current not being below a threshold value of the restraint current and the second signal indicating that the neutral current is above a fault threshold; and
transmitting a notification to a computing system based on the internal ground fault being present.

12. The method of claim 11, comprising:
determining, based on the operational current being below the threshold value of the restraint current, the presence of an external ground fault condition of the grounded wye winding; and
transmitting the notification to a computing system based on the external ground fault condition being present.

13. The method of claim 11, wherein the presence of the internal ground fault of the grounded wye winding is determined based on:
determining a first magnitude of a zero sequence of the three-phase current indicated by the first signal and a second magnitude of the neutral current indicated by the second signal;
determining whether the first magnitude is below an additional threshold value of the second magnitude; and
determining, based on the first magnitude being below the additional threshold value of the second magnitude, the presence of the internal ground fault of the grounded wye winding.

14. The method of claim 11, wherein the first signal is indicative of a zero-sequence of the three-phase current in the time domain and the second signal is indicative of the neutral current in the time domain, and wherein the first signal is indicative of a first one-cycle difference of the three-phase current, and the second signal is indicative of a second one-cycle difference of the neutral current.

15. The method of claim 14, wherein the grounded wye winding is included as part of a transformer, generator, shunt reactor, or motor of the power system.
